# EUROPEAN PATENT APPLICATION

(11) **EP 4 576 201 A1**
(43) Date of publication of application: **25.06.2025**
(21) Application number: 24220521.9
(22) Date of filing: 17.12.2024
(51) Int. Cl.: H01L 23/473

(54) **SYSTEM AND METHODS FOR A LIQUID COOLING PACKAGE ARCHITECTURE**

(30) Priority: 19.12.2023 US 202363612356 P; 19.08.2024 US 202418809318
(71) Applicant: Samsung Electronics Co., Ltd., Suwon-si, Gyeonggi-do 16677 (KR)
(72) Inventor: YANG, Jin, San Jose, CA 95134 (US); KIM, WooPoung, San Jose, CA 95134 (US)
(74) Representative: Kuhnen & Wacker Patent- und Rechtsanwaltsbüro PartG mbB

(57) **Abstract**

Disclosed herein are methods, systems and devices including a first layer (116) with at least one transistor, a second layer on a first side of the first layer (116), the second layer including a signal layer , a third layer on a second side of the first layer (116), the second side opposite the first side. The third layer may include a backside power delivery device (118). A liquid heat exchanger (102) may be connected to the signal layer, and the first layer (116), the second layer, the third layer and the liquid heat exchanger (102) may be stacked. The liquid heat exchanger (102) may include a first cooling layer (210), a second cooling layer (220) connected to the first cooling layer (210), and a third cooling layer (230) connected to the second cooling layer (220), the second cooling layer (220) between the first cooling layer (210) and the third cooling layer (230). The liquid heat exchanger (102) may include an inlet contacting the second cooling layer (220) and an outlet contacting the first cooling layer (210).

## Description

### TECHNICAL FIELD

The subject matter disclosed herein relates to microelectronics packaging and integrated circuits (IC) packaging. More particularly, the subject matter disclosed herein relates to a package architecture incorporating liquid cooling.

### BACKGROUND

Semiconductor devices may connect to additional devices and circuitry on different substrates. Forming connections between substrates can provide increased computation. However, forming connections between substrates can cause complications. Packaging describes the general method for connecting and integrating multiple computational components together in an integrated unit, and may involve multiple different types of integrated circuits on multiple substrates which may combine into a single unit. Packaging may also describe the method for which multiple computational components within a single unit are protected by the use of various techniques to provide thermal, physical and electrical protection. It is further noted that background concepts discussed herein are for informational purposes only and are not intended to limit the present disclosure. Nor should the background or field described herein be intended to limit the disclosure herein to a particular use or concept

### SUMMARY

An example embodiment provides a device including a first layer with at least one transistor, a second layer on a first side of the first layer, the second layer including a signal layer, a third layer on a second side of the first layer, the second side opposite the first side. The third layer may include a backside power delivery device. A liquid heat exchanger may be connected to the signal layer, and the first layer, the second layer, the third layer and the liquid heat exchanger may be stacked. The liquid heat exchanger may include a first cooling layer, a second cooling layer connected to the first cooling layer, and a third cooling layer connected to the second cooling layer, the second cooling layer between the first cooling layer and the third cooling layer. The liquid heat exchanger may include an inlet contacting the second cooling layer and an outlet contacting the first cooling layer. The third cooling layer may include a first set of fins supporting cooling liquid flowing in a first direction and a second set of fins supporting cooling liquid flowing in a second direction, the second direction opposite the first direction. The third cooling layer may include a first outlet contacting a first set of fins and a second outlet contacting a second set of fins, and a shared inlet contacting the second cooling layer, the first set of fins, and the second set of fins. A first outlet may contact the first cooling layer and a second outlet may contact the first cooling layer. The liquid heat exchanger may include a fluid flow path connecting an inlet to the second cooling layer, the second cooling layer to a shared inlet, the shared inlet to a first set of fins, the first set of fins to a first outlet, the first outlet to the first layer, and the first layer to an outlet. The liquid heat exchanger may be formed of silicon. The liquid heat exchanger may (thermally) contact the signal layer.

An example embodiment provides a system including a liquid heat exchanger, a first substrate with a first side, and a second side opposite the first side; a first cooling layer on the first side, the first cooling layer including a first set of fluidic conduits, an outlet connected to the first cooling layer, and a second cooling layer between the first cooling layer and the first substrate, the second cooling layer including a second set of fluidic conduits coupled to the first set of fluidic conduits; and an inlet connected to the second cooling layer. A third cooling layer may between the second cooling layer and the first substrate, the third cooling connected to the second cooling layer. The third cooling layer may include a first set of fins flowing in a first direction and a second set of fins flowing in a second direction opposite the first direction, and a base die may connect to the liquid heat exchanger. The liquid heat exchanger may be formed from silicon. An inlet may between the first set of fins and the second set of fins, with the inlet connecting the first set of fins and the second set of fins to the second set of fluidic conduits. A first outlet may connect to the first set of fins and a second outlet may connect to the second set of fins. The first outlet may connect the first set of fins to the second set of fluidic conduits, and the second outlet may connect the second set of fins to the second set of fluidic conduits. The first set of fins may include a first set of channels and the second set of fins may include a second set of channels. The base die may include a signal layer, a transistor layer, and a backside power delivery device.

An example embodiment may provide a method including forming a transistor layer with at least one transistor on a first side of a first substrate, forming a signal layer on the transistor layer, the transistor layer communicatively coupled to the transistor layer, forming a backside power delivery layer on a second side of the first substrate, the second side opposite the first side, the backside power delivery layer electrically coupled to the transistor layer. A liquid heat exchanger may be bonded to the signal layer, and the backside power delivery layer may be attached to a second substrate. The liquid heat exchanger may be bonded to the signal layer using a fusion bonding process. Bonding the liquid heat exchanger to the signal layer may include bonding a top manifold layer to a middle layer, the middle layer including a set of channels, and bonding the middle layer to a liquid carrier wafer. The liquid carrier wafer may include at least one fin. The set of channels of the middle layer may be aligned to at least one fin of the liquid carrier wafer.

### BRIEF DESCRIPTION OF THE DRAWING

In the following section, the aspects of the subject matter disclosed herein will be described with reference to exemplary embodiments illustrated in the figures, in which:
FIG. 1 depicts an enlarged cross-section view of an example embodiment of a packaging structure according to various embodiments of the subject matter disclosed herein;
FIG. 2 depicts an enlarged cross-section view of an example embodiment of a packaging structure according to various embodiments of the subject matter disclosed herein;
FIG.3 depicts a cross-section view of an example embodiment of a packaging structure assembly according to various embodiments of the subject matter disclosed herein;
FIG. 4A depicts a cross-section view of an example embodiment of a packaging structure assembly at a first time according to various embodiments of the subject matter disclosed herein;
FIG. 4B depicts a cross-section view of an example embodiment of a packaging structure assembly at a second time according to various embodiments of the subject matter disclosed herein;
FIG. 4C depicts a cross-section view of an example embodiment of a packaging structure assembly at a third time according to various embodiments of the subject matter disclosed herein;
FIG. 4D depicts a cross-section view of an example embodiment of a packaging structure assembly at a fourth time according to various embodiments of the subject matter disclosed herein;
FIG. 4E depicts a cross-section view of an example embodiment of a packaging structure assembly at a fifth time according to various embodiments of the subject matter disclosed herein;
FIG. 4F depicts a cross-section view of an example embodiment of a packaging structure assembly at a sixth time according to various embodiments of the subject matter disclosed herein;
FIG. 4G depicts a cross-section view of an example embodiment of a packaging structure assembly at a seventh time according to various embodiments of the subject matter disclosed herein;
FIG. 5 depicts an example embodiment of a method of forming a package structure according to various embodiments of the subject matter disclosed herein;
FIG. 6 depicts a schematic view of a cooling system including a cross-section view of an example embodiment of a packaging structure assembly according to various embodiments of the subject matter disclosed herein;
FIG. 7 depicts an enlarged cross-section view of an example embodiment of a packaging structure according to various embodiments of the subject matter disclosed herein; and
FIG. 8 depicts an enlarged cross-section view of an example embodiment of a packaging structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Row Select," "3D," etc.) may be interchangeably used with a corresponding non-capitalized version (e.g., "counter clockwise," "row select," "3d," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, the substrates may contain circuits such as integrated circuits including central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), graphical processing units (GPUs), other forms of auxiliary processing units (xPU), Artificial intelligence (AI) chips, High bandwidth memory (HBM) interfaces, and other application-specific integrated circuits (ASIC). In some embodiments, a combination of circuits may be present on a substrate. In some embodiments, a substrate may include a packaged chip.

As used herein, high bandwidth memory or HBM, may refer to a chip structure including one or more HBM modules. In some embodiments, the HBM may be manufactured by an advanced silicon node process.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via extending through an interposer such as another substrate or chip. In some embodiments, an interconnection may be formed using connections on a surface of a substrate, such as a pad, and may use additional materials between the pads such as solder to form an interconnection.

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, the term fluidically coupled, fluidically connected, fluid path, fluidic flow path, and fluid flow path may refer to a route or path a fluid may travel, and may include one or more intermediate steps between two objects said to be fluidically coupled.

As discussed herein, a structure may be formed using power delivery networks and signal networks in a modular structure with additional computational components such as memory and processing devices. Such a modular structure may create an increase in circuity density, which may, however increase the thermal energy which may be generated or trapped within a such a modular structure. As such, disclosed herein are various embodiments of devices, systems and methods related to packaging architecture to combine backside power delivery networks (BSPDNs), signal networks, and embedded liquid cooling. In some embodiments, a BSPDN may be formed on the backside of a substrate, with a signal network formed on the front side of the same substrate. In some embodiments, the BSPDN and signal network may be formed on separate substrates and transferred to the same substrate. The BSPDN and signal network may be separated by a transistor layer. The transistor layer may include a plurality of transistors. The transistors may provide different functions and take different forms, including a logic layer. The BSPDN and signal network may form a single monolithic structure on the same die in a semiconductor foundry process, which may be known as a base chip. A liquid cooling module may be separately formed in a semiconductor manufacturing process, and assembled in a packaging assembly process. In some embodiments, a signal network may be referred to as a signal network layer or a signal layer. In some embodiments, a backside power delivery network or BSPDN may be referred to as a backside power delivery device, a backside power delivery layer, or a backside power delivery network layer.

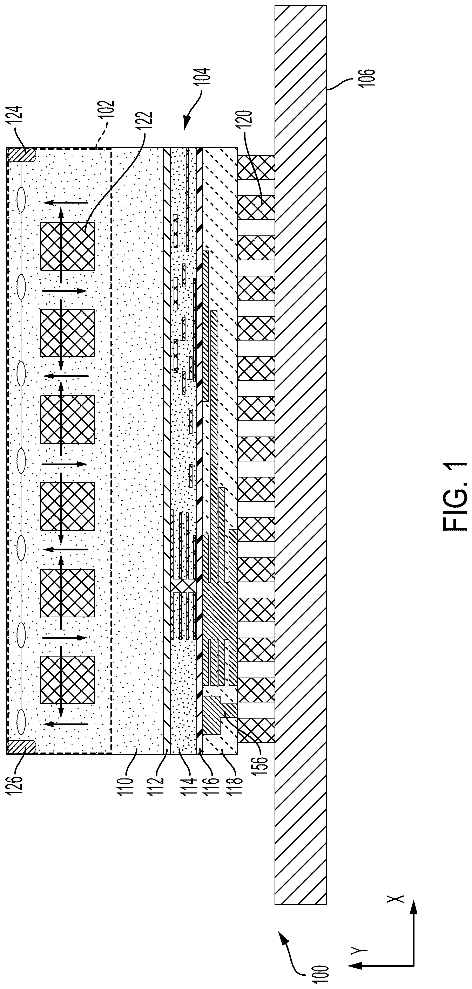

FIG. 1 depicts an exemplary embodiment of a cooling package architecture 100 which integrates a chip using backside power delivery with a liquid cooling module 102. In cooling package architecture 100, a liquid cooling module 102 is coupled with a base chip 104 with power and signal layers and mounted on a supporting substrate 106 in a stack formation.

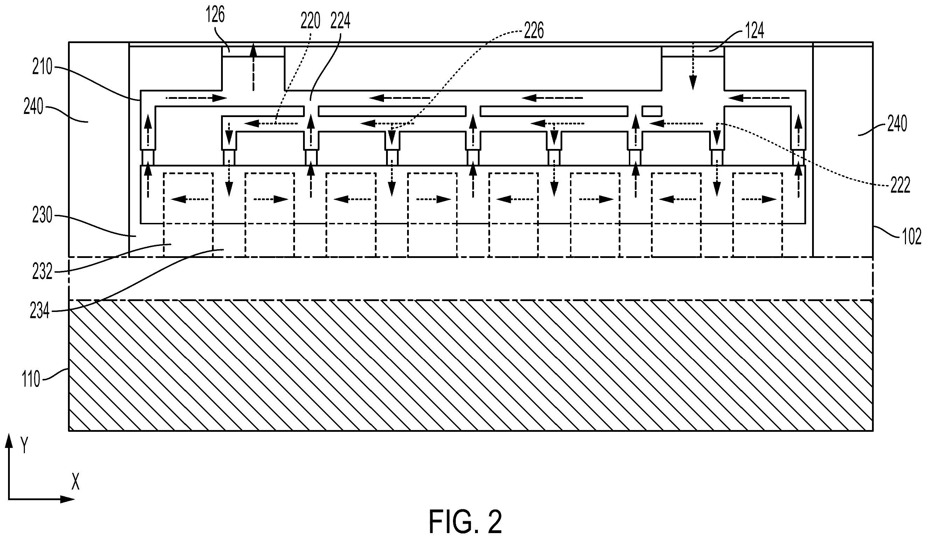

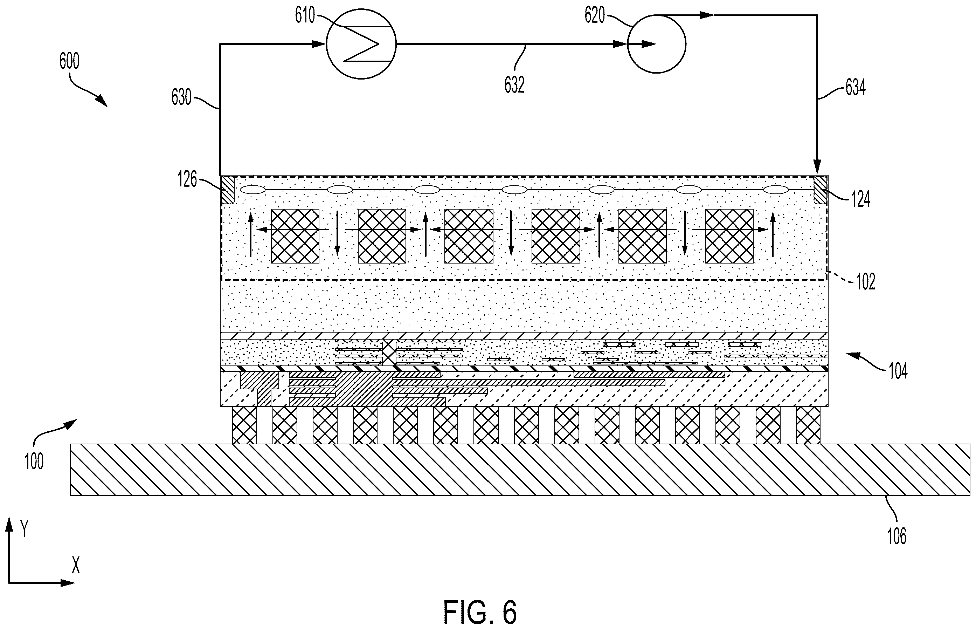

The liquid cooling module 102 may form the top of the stack formation of the cooling package architecture 100, although in another embodiment the stack may be inverted with the liquid cooling module 102 forming the bottom of the stack formation. The liquid cooling module 102 may include a plurality of channels 122 for carrying liquid coolant within the liquid cooling module 102. As used herein, a liquid cooling module may be referred to in some embodiments as a liquid heat exchanger, or fluid heat exchanger. The base of the liquid cooling module 102 may be a carrier wafer layer 110, made from a substrate material such as silicon (Si). The liquid coolant carried within the liquid cooling module 102 can be provided as one or more of a number of coolants, which may be liquid at or near room temperature (e.g., water, alcohols, glycols, etc., or various combinations thereof). The liquid coolant may enter the liquid cooling module 102 via an inlet 124 and exit the liquid cooling module 102 via an outlet 126. As further discussed below with reference to FIG. 6, the inlet 124 and the outlet 126 may form a closed loop system with a pump connecting a coolant line from the outlet 126 to the inlet 124 to form a fluid flow path. See also FIG. 2 below for a further discussion of the liquid cooling module 102.

The base chip 104 is bonded to the carrier wafer layer 110 of liquid cooling module 102 by a bonding layer 112. The carrier wafer layer 110 holds the liquid cooling module 102, and may be made of a substrate material such as silicon. The bonding layer 112 provides a bond between the base chip 104 and the liquid cooling module 102, both securing the liquid cooling module 102 to the base chip 104 and providing thermal transport between the base chip 104 and the liquid cooling module 102. In some embodiments, the bonding layer 112 may be made of a dielectric material such as silicon oxide (SiO₂) or silicon nitride (Si₃N₄). The bonding layer 112 may contact a signal layer 114 of the base chip 104, which may in turn contact a transistor layer 116 of the base chip 104. The signal layer 114 may be a signal network layer. The bonding layer 112 may provide a thermal path for the signal layer 114 to thermally couple the base chip 104 to the liquid cooling module 102.

The signal layer 114 may comprise a network-on-a-chip (NOC), and may provide interconnections to transport signals for other layers, including the transistor layer 116. In some embodiments, the signal layer 114 may provide packet routing. In some embodiments, the signal layer 114 may be provided as a multi-layer structure capable of providing signal routing. In some embodiments, the signal layer 114 may comprise a plurality of conductive channels embedded within a dielectric material, and the plurality of conductive channels may be arranged in multiple layers, with the size of the conductive channels decreasing in distance from the transistor layer 116. In some embodiments, the signal layer 114 may have a plurality of conductive channels in 4, 8, 10, 12 or more layers. In some embodiments, the conductive channels may be conductive lines formed of a material such as a metal, including copper.

The transistor layer 116 separates the signal layer 114 from a power layer 118 of the base chip 104 and includes a plurality of transistors. As used herein, the transistor layer 116 may be used to refer to both the layer containing the plurality of transistors and the plurality of transistors. In some embodiments, the transistor layer 116 may act as the base logic for both the signal layer 114 and the power layer 118. In other embodiments, the transistor layer 116 along with the signal layer 114 and the power layer 118 may provide the base logic for a memory device. The transistor layer 116 may be communicatively coupled to the signal layer 114 and may be electrically coupled to the power layer 118.

The power layer 118 provides a power delivery network for routing power supply lines on the back side of the transistor layer 116 and may provide both power and reference voltages to transistors in transistor layer 116. The power layer 118 may also be known as a backside power delivery network layer or BSPDN layer. The power layer 118 may include multiple different layers of power supply lines 156 routing power within an insulating material. In some embodiments the insulating material may include a dielectric material. In some embodiments, the power layer 118 may include 4 to 6 layers of power supply lines and, in some embodiments, the size of the power supply lines may decrease as they approach the transistor layer 116. The power supply lines may be comprised of conductive materials, including various forms of low resistive metals, such as copper, alternatively or in addition, the conductive materials may include various forms of other conductive materials, including doped carbon.

The power layer 118 may be coupled to the supporting substrate 106 with interconnects 120. In some embodiments, a plurality of pads, plugs and vias may be used to couple the power layer 118 to the supporting substrate 106. The interconnects 120 may include pads, bumps, microbumps, pillars, balls, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The interconnects 120 may further include a dielectric material, which may include a material such as an adhesive, resin, or elastomer which may form a connection between the power layer 118 and the supporting substrate 106 in addition to a conductive connection. In some embodiments, the combination of a conductive connection and a dielectric connection may form a hybrid bond. The supporting substrate 106 may in turn connect to other devices and dies, and in some embodiments, may take the form of an interposer. The supporting substrate 106 may be made of various materials, including organic materials, as well semiconductor materials such as silicon either alone or in combination with another material, such as a semiconductor-on-insulator substrate.

FIG. 2 depicts an enlarged view of an example embodiment of the liquid cooling module 102. The liquid cooling module 102 may have three layers of fluidic conduits embedded therein, including a first cooling layer 210, a second cooling layer 220, and a third cooling layer 230, the three layers of fluidic conduits forming a fluid flow path. The first cooling layer 210 may also be referred to as a manifold layer or top manifold layer and may connect directly to the inlet 124 and the outlet 126. The second cooling layer 220 may also be referred to as a middle layer and may connect directly to the first cooling layer 210 and the third cooling layer 230. The third cooling layer 230 may also be referred to as a fin layer, and includes a plurality of fins 232 with a corresponding plurality of channels 234 in contact with the plurality of fins 232. In some embodiments, the first cooling layer 210, the second cooling layer 220, and the third cooling layer 230 may each be substantially planar, and extend in parallel directions. A first set of connections 224 may connect the first cooling layer 210 to the second cooling layer 220 and a second set of connections 226 may connect the second cooling layer 220 to the third cooling layer 230. In some embodiments, the first set of connections 224 and the second set of connections 226 may be aligned to each other. In some embodiments, the first set of connections 224 and the second set of connections 226 may be staggered or offset relative to one another, and may thus direct cooling liquid between the first cooling layer 210 and the third cooling layer 230 with the second cooling layer 220. In some embodiments, a first portion of the second set of connections 226 may be aligned with the first set of connections 224 to create an upward passage, while a second portion of the second set of connections 226 may be offset from the first set of connections 224 to create a downward passage.

In some embodiments, the inlet 124 may connect directly to both the first cooling layer 210 and the second cooling layer 220, with a section 222 of the inlet 124 extending into the second cooling layer 220. In some embodiments, the outlet 126 may connect to only the first cooling layer 210. A direct connection between the inlet 124 and the second cooling layer 220 may reduce the pressure drop across the liquid cooling module 102 by more efficiently transporting the cooling liquid across the liquid cooling module 102 via the second cooling layer 220 and into the third cooling layer 230.

The third cooling layer 230 may contain the plurality of fins 232 and the corresponding plurality of channels 234. The plurality of fins 232 may be a series of fins extending vertically from the carrier wafer layer 110, the corresponding plurality of channels 234 being formed between the plurality of fins 232. The plurality of fins 232 may be formed into a series of sets of fins, which may be referred to as fin banks, each fin bank extending between a pair of the second set of connections 226.

As shown in the exemplary embodiment of FIG. 2, the cooling liquid may enter the liquid cooling module 102 at the inlet 124. As the inlet 124 connects via the section 222 to the second cooling layer 220, the cooling liquid may then be distributed out and across the second cooling layer 220, before the cooling liquid flows into the third cooling layer 230 via a downward portion of the second set of connections 226 which act as a shared inlet into a set of fin banks in the third cooling layer 230. In the third cooling layer 230, the cooling liquid contacts at least one of the plurality of fins 232 and flows via at least one of the corresponding plurality of channels 234, where a thermal exchange may warm the cooling liquid. When warmed, the cooling liquid rises from the third cooling layer 230 via an upward portion of the second set of connections 226 acting as a shared outlet between fin banks, back to the second cooling layer 220. The upward portion of the second set of connections 226 may be aligned with the first set of connections 224 such that the warmed cooling liquid flows directly to the first cooling layer 210. The warmed cooling liquid within the first cooling layer 210 then flows to the outlet 126.

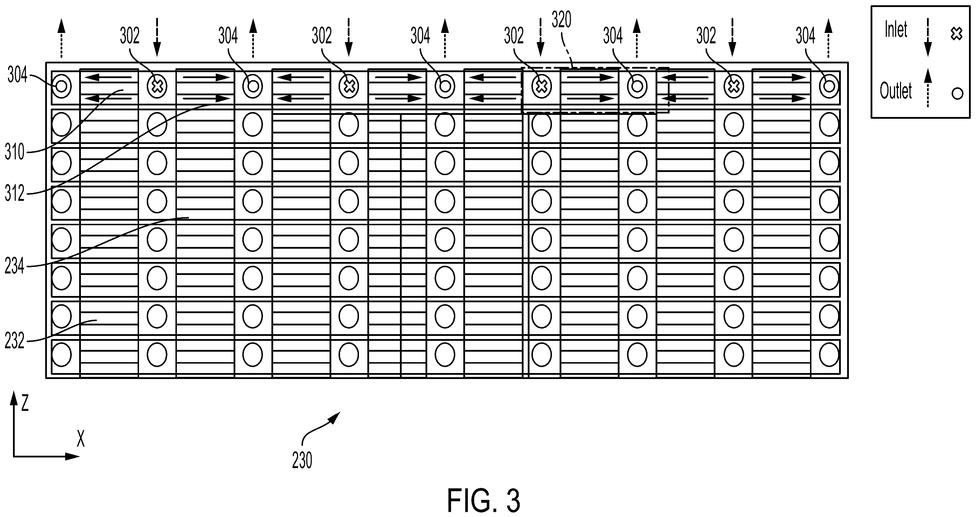

FIG. 3 depicts an illustrative embodiment of a plan view of the third cooling layer 230. Within the plan view of FIG. 3, the flow of cooling liquid is shown with respect to the plurality of fins 232 as configured in a series of fin banks 320 (indicated by the dashed rectangle). Each fin bank 320 includes a shared inlet connection 302, an outlet connection 304, at least one fin of the plurality of fins 232 and at least one channel of the corresponding plurality of channels 234. The cooling liquid may enter the third cooling layer 230 via the shared inlet connection 302 (which may be a connection of the second set of connections 226) and exit the third cooling layer 230 via the outlet connection 304 (which may be another connection of the second set of connections 226). The cooling liquid may then flow within the third cooling layer 230 in one of the corresponding plurality of channels 234 which extend between a shared inlet connection 302 and an outlet connection 304, and alongside at least one fin of the plurality of fins 232. In the example of FIG. 3, the cooling liquid flows along the X axis, and may flow in either the positive X direction (i.e., in the direction of the X axis arrow) or negative X direction (i.e., in the opposite direction of the X axis arrow) from a shared inlet connection 302 to an adjacent outlet connection 304 on either side of the shared inlet connection 302. In some embodiments, the cooling liquid may flow along the Z axis, or may flow in a multi-directional route along a combination of the X axis and the Z axis. In some embodiments, a shared inlet connection 302 may connect to only a single outlet connection 304 within the third cooling layer 230, while in other embodiments a shared inlet connection 302 may connect to a plurality of outlet connections 304 within the third cooling layer 230.

The plurality of fin banks 320 may be arranged in a set of rows, and in some embodiments may be arranged in a set of columns. In some embodiments, the plurality of fin banks 320 may extend across substantially the entirety of the third cooling layer 230. The plurality of fin banks 320 may be fluidically connected in series in parallel, or a combination thereof. The number of fin banks 320 in the plurality of fin banks 320 in a row may be adjusted based on the size of the liquid cooling module 102. In some embodiments, the number of fin banks in the plurality of fin banks 320 in a row may be at least 2, at least 4, at least 8, or more. In some embodiments, each bank of the plurality of fin banks 320 may extend only a portion of the distance across the third cooling layer 230. By using a plurality of fin banks 320 in each row, the pressure drop across the entirety of the liquid cooling module 102 may be reduced compared to using a single fin bank for each row, as the cooling liquid may more efficiently flow across the plurality of fins 232. As shown in FIG. 3, the third cooling layer 230 comprises a first set of fins 232 supporting cooling liquid flowing in a first direction, e.g. the X-direction, and a second set of fins 232 supporting cooling liquid flowing in a second direction, the second direction opposite the first direction. Exemplarily, the third cooling layer 230 comprises a first outlet 304 contacting the first set of fins 232, a second outlet 304 contacting the second set of fins 232, and a shared inlet 302 contacting the second cooling layer 220, the first set of fins 232 and the second set of fins 232. As can be seen from FIGS. 2 and 3, the third cooling layer 230 may comprise a first outlet 304 that contacts the first cooling layer 210 and a second outlet that contacts the first cooling layer 210.

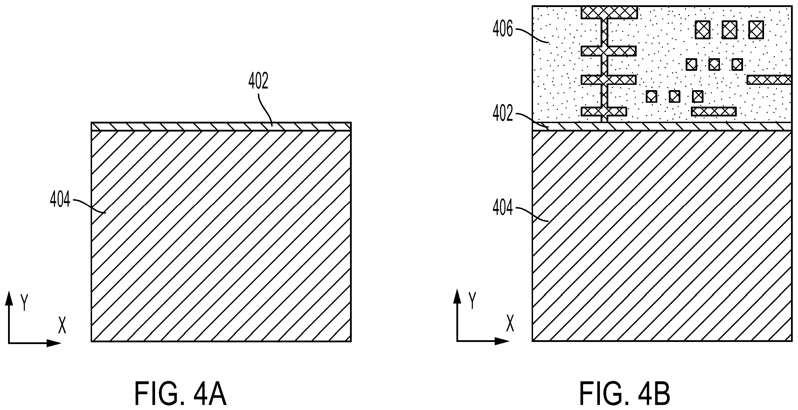

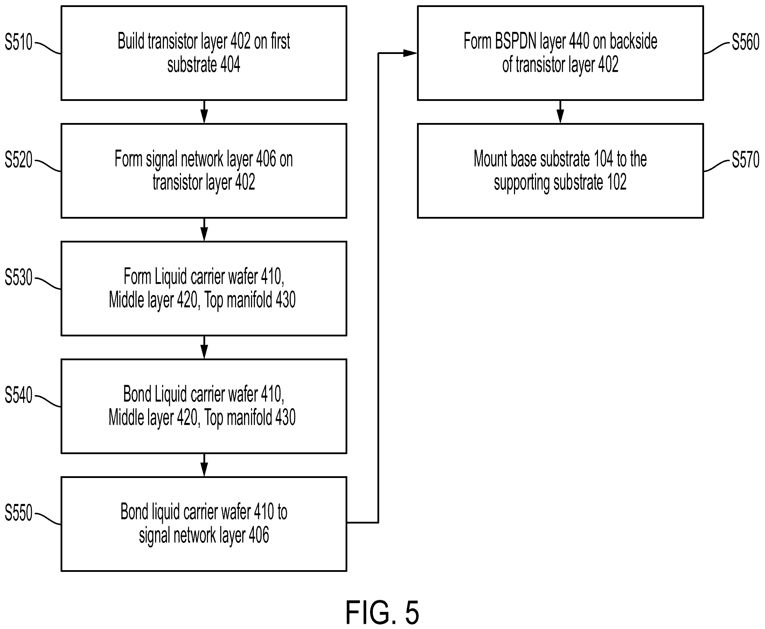

FIGS. 4A-4G depict an illustrative embodiment of the packaging process of a cooling assembly 400. FIG. 5 depicts an example embodiment of a process 500 for forming a package structure corresponding to the illustrative embodiment of FIGS. 4A-4G. The cooling assembly 400 may take the form of the cooling package architecture 100.

FIG. 4A depicts step S510 in FIG. 5 where a transistor layer 402 is formed on a first substrate 404. In some embodiments, the transistor layer 402 may be the transistor layer 116. The transistor layer 402 may be formed using complementary metal-oxide-semiconductor (CMOS) processes, such as depositing, lithography, etching, passivation, etc. In some embodiments, the first substrate 404 may be a silicon wafer, while in other embodiments, the first substrate 404 may include other semiconductor materials such as germanium, or may take the form of other substrates such as an organic substrate or even a SOI substrate such as glass. In some embodiments, the first substrate may be a sacrificial substrate. The transistor layer 402 and structures built directly on the transistor layer 402 may be referred to as front-side layers.

FIG. 4B depicts step S520 in FIG. 5 where a signal network layer 406 is formed on the transistor layer 402. In some embodiments, the signal network layer 406 may be the signal layer 114. The signal network layer 406 may be formed using CMOS processes to build the various conductive, dielectric and insulative portions of the signal network layer 406 directly on to the transistor layer 402. Alternatively, in some embodiments, the signal network layer 406 may be fully formed and bonded directly to the transistor layer 402.

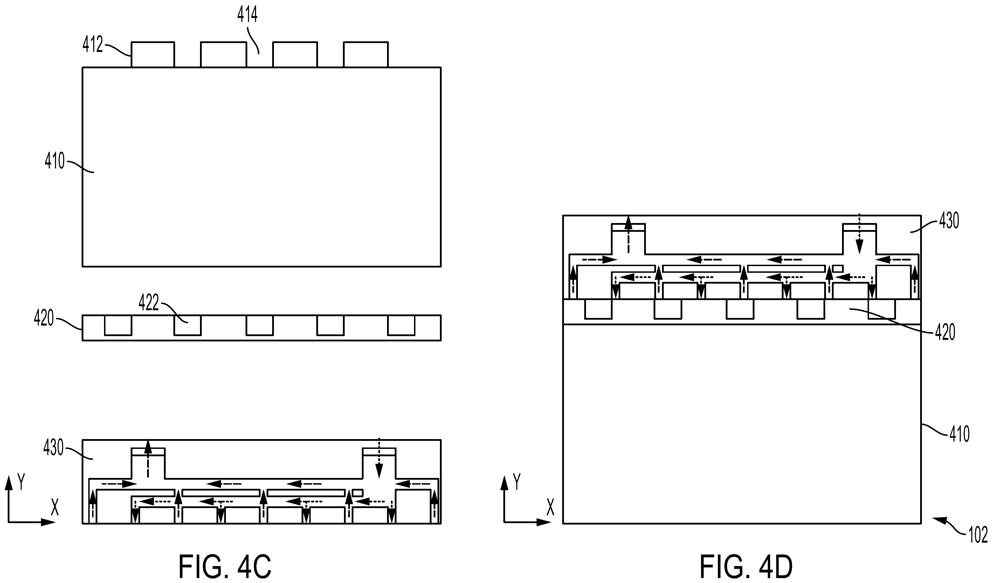

FIG. 4C depicts step S530 in FIG. 5 where three separate components are formed, which are to be assembled together: a liquid carrier wafer 410, a middle layer 420 and a top manifold 430. The liquid carrier wafer 410 has fins 412 and channels 414 formed on a top side thereof. The fins 412 and channels 414 may be formed in a positive process by building directly on the liquid carrier wafer 410 using a combination of CMOS processes to deposit a new layer directly on the liquid carrier wafer 410 and patterning the new layer to form the fins 412 and channels 414. The fins 412 and channels 414 may alternatively, or in combination with the positive process, be formed in a negative process where a surface of the liquid carrier wafer 410 is patterned and removed to form trenches corresponding to channels 414 between the fins 412. The liquid carrier wafer 410 may be made of a semiconductor material, for example, silicon. A middle layer 420 may be separately formed using CMOS processes with a series of embedded channels 422. The middle layer 420 may be formed on a separate semiconductor substrate and planarized. The top manifold 430 may also separately formed using CMOS processes, and may also be formed initially on a separate semiconductor substrate. The top manifold 430 may be provided as the aforementioned first cooling layer 210, the middle layer 420 may be provided as the aforementioned second cooling layer 220, and the layer formed by the fins 412 and the channels 414 may be the aforementioned third cooling layer 230.

FIG. 4D depicts step S540 in FIG. 5 where the top manifold 430, the middle layer 420 and the liquid carrier wafer 410 are bonded together to form the liquid cooling module 102. As the top manifold 430, the middle layer 420 and the liquid carrier wafer 410 may each be made of the same semiconductor material such as silicon, a fusion bonding process may be used to bond the layers together. In fusion bonding, material layers such as silicon may directly bond together without an intermediate material, and may use heat in a thermal process to cause like materials to bond directly together. In some embodiments, other techniques for bonding may be used either in place of or in combination with fusion bonding, including for example, the use of an adhesive bonding layer.

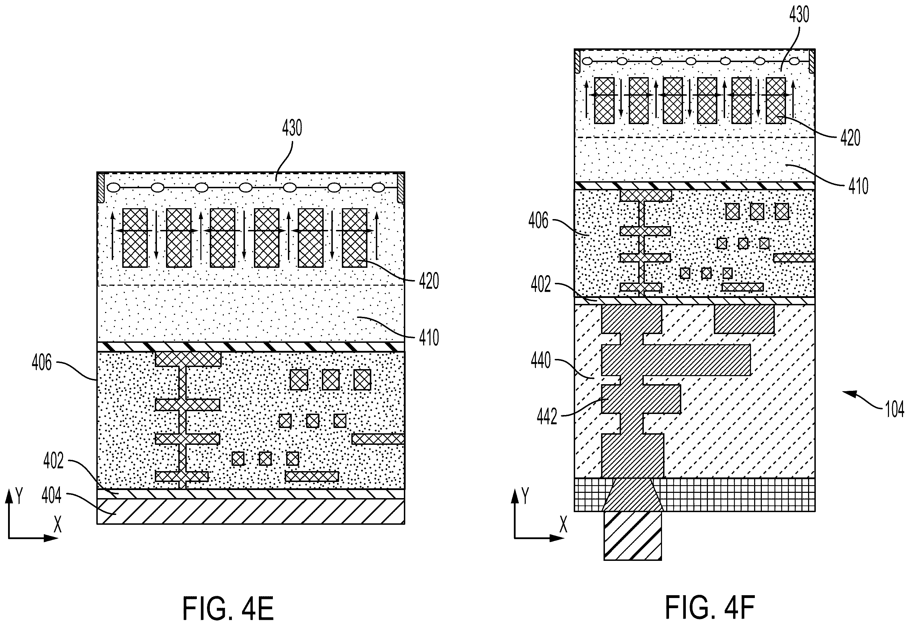

FIG. 4E depicts step S550 in FIG. 5 where the liquid cooling module 102, including the top manifold 430, the middle layer 420 and the liquid carrier wafer 410 are bonded to the first substrate 404. The liquid carrier wafer 410 may be bonded to the signal network layer 406 via fusion bonding. In some embodiments, other forms of bonding may be used either in place of or in combination with fusion bonding, including for example, the use of an adhesive bonding layer. In some embodiments, a thin film of dielectric material may be deposited on the signal network layer 406 prior to bonding the liquid cooling module 102. In some embodiments, the first substrate 404 may be fully or partially removed using a variety of processes, including one or more of grinding, polishing, etching, and peeling processes, including chemical mechanical polishing (CMP). A remaining portion of the first substrate 404 may be planarized to provide a flat surface suitable for additional CMOS processing. The liquid carrier wafer 410 may be in thermal contact with the signal network layer 406.

FIG. 4F depicts step S560 in FIG. 5 where a power layer 440 is formed on the backside of the transistor layer 402. In some embodiments, the power layer 440 is formed using CMOS processing. The power layer 440 may be formed by building directly on the backside of the transistor layer 402 by depositing additional materials on the remaining substrate layer 310, or may be formed in the first substrate 404 by conducting patterning steps such as lithography and etching to build trenches, vias, and holes within the remaining substrate layer 310. In some embodiments, the power layer 440 may be formed by both building directly on the first substrate 404 and conducting patterning steps to build within the first substrate 404. In some embodiments, multiple power layers may be formed with each layer stacking on the previous layer. In some embodiments, the power layer 440 may be produced on a separate substrate and transferred to the backside of the transistor layer 402. In some embodiments, the power layer 440 may be a BSPDN layer. In some embodiments, the power layer 440 may be the power layer 118. In some embodiments, the power layer 440, the transistor layer 402 and the signal network layer 406 may form the base chip 104.

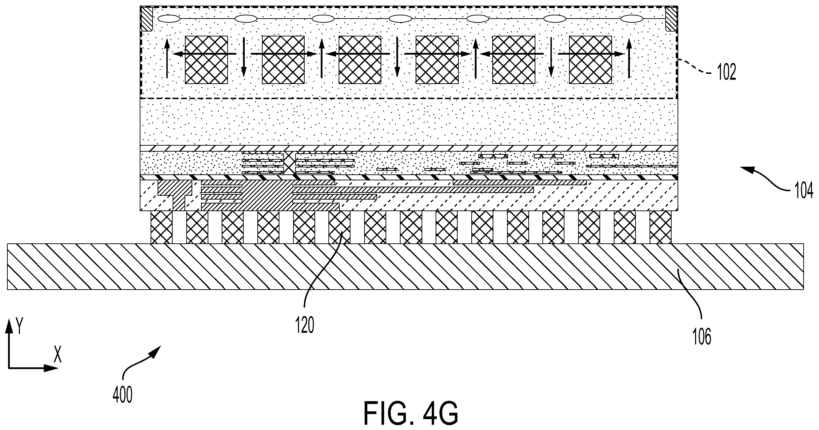

FIG. 4G depicts step S570 in FIG. 5 the assembly of the structure of FIG. 4F including the liquid cooling module 102 and the base chip 104 onto the supporting substrate 106. The bottom surface of the base chip 104 may include the power layer 440, which may be bonded using the interconnects 120 to the supporting substrate 106. The techniques used for forming interconnects 120 include various forms of metal bonding such as pads, bumps, microbumps, pillars, balls, to directly connect between the base chip 104 and the power layer 440. In some embodiments, a dielectric material or adhesive material, including underfill may also be included.

FIG. 6 depicts an illustrative embodiment of a cooling system 600 including the cooling package architecture 100. The liquid cooling module 102 is fluidly connected to a heat exchanger 610 and a pump 620. In some embodiments, one or more of the pump 620 may connect the liquid cooling module 102 to one or more of the heat exchanger 610, and the one or more of the heat exchanger 610 may transfer heat away from the liquid coolant. In some embodiments, the pump 620 may be placed before the heat exchanger 610, in some embodiments the pump 620 may be placed after the heat exchanger 610, and in some embodiments, a pump 620 may be placed before and after the heat exchanger 610. In some embodiments, an open loop arrangement may be used, for example, with a flow of liquid cooling circulating only a single time between the inlet 124 and the outlet 126.

The heat exchanger 610 may be any suitable form of heat exchanger, such as radiators, cooling plates, helical coils, heat pumps, phase change exchangers, evaporators, etc. In some embodiments, the heat exchanger 610 may transfer heat from the cooling liquid to a secondary cooling fluid, such as air or water. In some embodiments, multiple cooling loops may be provided to provide further cooling to the secondary cooling fluid.

The pump 620 may be any suitable pump for transferring a cooling liquid, and may take the form of any suitable pump, including a positive displacement pump, a volumetric pump, a centrifugal pump, an axial-flow pump, or some combination thereof.

As shown in the illustrative embodiment of FIG. 6, a first cooling line 630 may fluidly couple the outlet 126 to the heat exchanger 610, a second cooling line 632 may fluidly couple the heat exchanger 610 to the pump 620, a third cooling line 634 may fluidly couple the pump 620 to the inlet 124. The first cooling line 630, the second cooling line 632, and the third cooling line 634 may be some combination of pipes, tubing, and hoses, and may be made from a variety of materials including metal, rubbers, and various forms of polymers. In some embodiments, a single cooling line may be made of a conductive metal such as copper and provide radiative cooling either alone or in combination with additional heat exchangers. In some embodiments, multiple heat exchangers and pumps may be used in each cooling system, with the heat exchangers and pumps arranged in a serial configuration, a parallel configuration, or a combination thereof.

In some embodiments, the liquid cooling module 102 may be formed using additive manufacturing processes such as 3D printing. In some embodiments the liquid cooling module 102 may be printed of materials such as ceramics, while in other embodiments, other known types of fused deposition materials may be used.

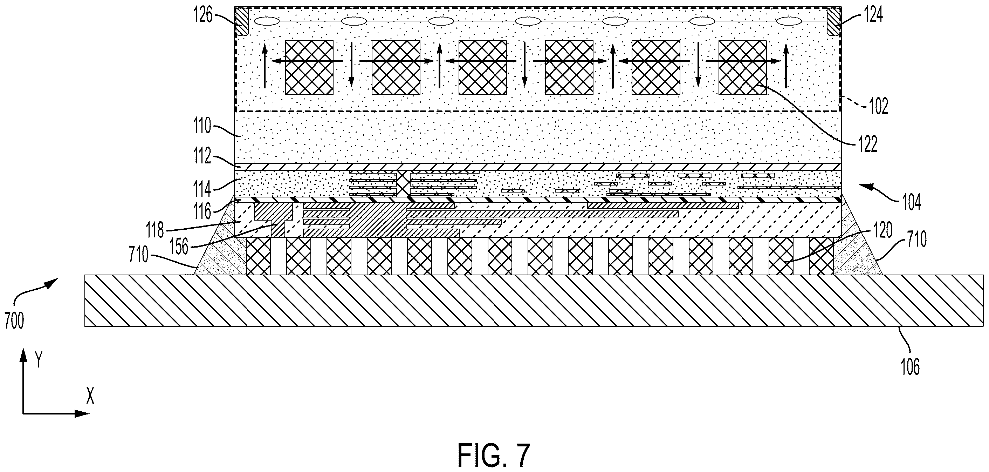

FIG. 7 depicts an illustrative embodiment of a cooling package architecture 700. The cooling package architecture 700 differs from the cooling package architecture 100 by including an underfill 710 coupling the base chip 104 to the supporting substrate 106. In some embodiments, the underfill 710 may be a solidified liquid underfill material, and in some embodiments, the underfill 710 may be a molded underfill material. For example, in some embodiments, an adhesive such as a resin or epoxy may be inserted into the gaps between the base chip 104 and the supporting substrate 106. In some embodiments, the adhesive may be subjected to an overmolding process providing external pressure on the adhesive. The adhesive may, in some embodiments, be subjected to a curing process such as the application of heat and may be solidified. The underfill may provide additional mechanical support to the base chip 104, and may strengthen the connection to the supporting substrate 106.

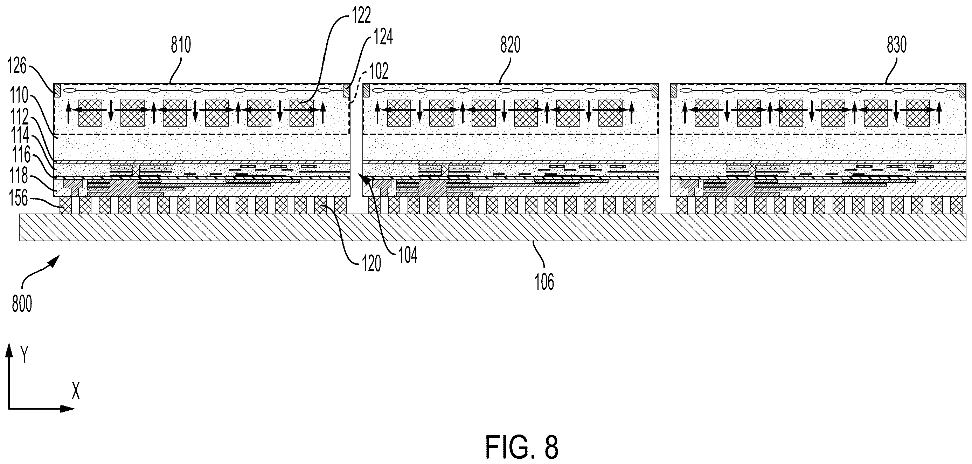

FIG. 8 depicts an illustrative embodiment of a cooling package array 800. The cooling package array 800 may include multiple cooling packages on a shared substrate. In the example embodiment of FIG. 8, a first cooling package 810, a second cooling package 820, and a third cooling package 830 are depicted on the shared supporting substrate 106. The number of packages on a shared substrate may vary based on the size of the individual packages and spacing, and may be aligned in rows and columns along the x-axis and z-axis. The number of packages in each row and column may vary, for example, including 2, 3, 4, 5, 6, or more packages in a row. In some embodiments, the packages may be arranged in a regular spacing, while in other embodiments, the packages may be arranged in an irregular spacing. In some embodiments, the packages may be arranged in a polygon arrangement, such as a rectangle, circle, star, or other polygon.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first layer (116) including at least one transistor;
a second layer on a first side of the first layer (116), the second layer including a signal layer (114);
a third layer on a second side of the first layer (116), the second side opposite the first side, the third layer including a backside power delivery device (118); and
a liquid heat exchanger (102) connected to the signal layer (114);
wherein the first layer (116), the second layer, the third layer and the liquid heat exchanger (102) are stacked.

2. The device of claim 1, wherein the liquid heat exchanger (102) includes:
a first cooling layer (210);
a second cooling layer (220) connected to the first cooling layer (210); and
a third cooling layer (230) connected to the second cooling layer (220),
wherein the second cooling layer (220) is between the first cooling layer (210) and the third cooling layer (230).

3. The device of claim 2, wherein the liquid heat exchanger (102) includes:
an inlet (124) contacting the second cooling layer (220); and
an outlet (126) contacting the first cooling layer (210).

4. The device of claim 2, wherein the third cooling layer (230) comprises a first set of fins (232) supporting cooling liquid flowing in a first direction (X) and a second set of fins (232) supporting cooling liquid flowing in a second direction, wherein the second direction is opposite to the first direction (X).

5. The device of claim 4, wherein the liquid heat exchanger (102) comprises:
a first substrate (110) having a first side and a second side opposite the first side, wherein the first cooling layer (210) is on the first side, the first cooling layer (210) including a first set of fluidic conduits;
an outlet connected to the first cooling layer (210), wherein the second cooling layer (220) is between the first cooling layer (210) and the first substrate (110), the second cooling layer (220) including a second set of fluidic conduits coupled to the first set of fluidic conduits; and
an inlet (124) connected to the second cooling layer (220), wherein the third cooling layer is between the second cooling layer (220) and the first substrate (110); and
a base die (104) connected to the liquid heat exchanger (102), wherein the base die (104) comprises the first layer (116), the second layer and the third layer.

6. The device of claim 5, wherein the third cooling layer (230) comprises an inlet (302) between the first set of fins (232) and the second set of fins (232),
wherein the inlet (302) of the third cooling layer (230) connects the first set of fins (232) and the second set of fins (232) to the second set of fluidic conduits.

7. The device of claim 5 or 6, wherein the third cooling layer (230) further comprises a first outlet (304) connected to the first set of fins (232) and a second outlet (304) connected to the second set of fins (232);
wherein the first outlet (304) of the third cooling layer (230) connects the first set of fins (232) to the second set of fluidic conduits; and
wherein the second outlet (304) of the third cooling layer (230) connects the second set of fins (232) to the second set of fluidic conduits.

8. The device of any one of claims 5 to 7, wherein the first set of fins (232) comprises a first set of channels and the second set of fins (232) comprises a second set of channels.

9. The device of claim 2 or 3, wherein the third cooling layer (230) further comprises:
a first outlet (304) contacting a first set of fins (232);
a second outlet (304) contacting a second set of fins (232); and
a shared inlet (302) contacting the second cooling layer (220), the first set of fins (232) and the second set of fins (232).

10. The device of any one of claims 2 to 6, wherein the third cooling layer (230) comprises a first outlet (304) that contacts the first cooling layer (210) and a second outlet (304) that contacts the first cooling layer (210), and/or
wherein the liquid heat exchanger (102) further includes a fluid flow path connecting an inlet (124) of the liquid heat exchanger (102) to the second cooling layer (220), the second cooling layer (220) to a shared inlet (302) of the third cooling layer (230), the shared inlet (302) to a first set of fins (232), the first set of fins (232) to a first outlet (304) of the third cooling layer (230), the first outlet (304) to the first cooling layer (210), and the first cooling layer (210) to an outlet (126) of the liquid heat exchanger (102).

11. The device of any one of claims 1 to 10, wherein the liquid heat exchanger (102) is formed of a material comprising silicon, and/or
wherein the liquid heat exchanger (102) thermally contacts the signal layer (114).

12. A method comprising:
forming (S510) a transistor layer (402) on a first side of a first substrate (404), the transistor layer (402) including at least one transistor;
forming (S520) a signal layer (406) on the transistor layer (402), the signal layer (406) communicatively connected to the transistor layer (402);
forming (S560) a backside power delivery layer (440) on or in a second side of the first substrate (404), the second side opposite the first side, the backside power delivery layer (440) electrically connected to the transistor layer (402);
bonding (S540, S550) a liquid heat exchanger (102) to the signal layer (406); and
attaching (S570) the backside power delivery layer (440) to a second substrate (106).

13. The method of claim 12, wherein bonding (S540, S550) the liquid heat exchanger (102) to the signal layer (406) includes a fusion bonding process, and/or
wherein bonding (S540, S550) the liquid heat exchanger (102) to the signal layer (406) includes bonding a top manifold layer (430) to a middle layer (420), the middle layer (420) comprising a set of channels, and bonding the middle layer (420) to a liquid carrier wafer (410).

14. The method of claim 12, wherein bonding (S540, S550) the liquid heat exchanger (102) to the signal layer (406) includes bonding a top manifold layer (430) to a middle layer (420), the middle layer (420) comprising a set of channels, and bonding the middle layer (420) to a liquid carrier wafer (410), and
wherein the liquid carrier wafer (410) comprises at least one fin (412).

15. The method of claim 14, wherein the set of channels of the middle layer (420) are aligned to the at least one fin (412) of the liquid carrier wafer (410).
